(19) **Europäisches Patentamt**
**European Patent Office**
**Office européen des brevets**

(11) **EP 2 264 894 B1**

(12) **EUROPEAN PATENT SPECIFICATION**

(45) Date of publication and mention
of the grant of the patent:
**12.10.2011 Bulletin 2011/41**

(51) Int Cl.:
***H03K 17/0814*** *(2006.01)* ***H01L 25/00*** *(2006.01)*

(21) Application number: **09008091.2**

(22) Date of filing: **19.06.2009**

(54) **Power module with additional transient current path and power module system**

Leistungsmodul mit zusätzlichem transientem Strompfad und Leistungsmodulsystem

Module d'alimentation avec un chemin de courant transitoire supplémentaire et système de module d'alimentation

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**22.12.2010 Bulletin 2010/51**

(73) Proprietor: **Vincotech Holdings S.a.r.l.**
**2636 Luxembourg (LU)**

(72) Inventors:
• **Frisch, Michael**
**82008 Unterhaching (DE)**

• **Temesi, Ernö**
**Nagykovácsi 2094 (HU)**

(74) Representative: **Grünecker, Kinkeldey,**
**Stockmair & Schwanhäusser**
**Anwaltssozietät**
**Leopoldstrasse 4**
**80802 München (DE)**

(56) References cited:
**EP-A- 0 379 346** **EP-A- 0 823 773**
**EP-A- 1 143 603** **EP-A- 1 768 244**
**US-A- 5 907 475** **US-A1- 2005 225 955**

**Description**

The present invention relates to power modules for controlling an input current to provide an output current. In particular, the present invention relates to such a power module comprising at least one semiconductor switch for controlling the input current and a circuit substrate. The circuit substrate has at least one input terminal for being connected to an input voltage and at least one output terminal for outputting the output voltage. The input terminal and the output terminal are connected to each other via a main current path that is controlled by the semiconductor switch.

Generally, parasitic inductances are a major problem with such power modules, in particular in fast switching applications. The parasitic inductance causes overvoltages and increases switch-off losses in the semiconductor. In particular, when using an insulated gate bipolar transistor (IGBT), the switching off of the semiconductor switch results in a current change and this causes an overvoltage spike by the current change in the parasitic inductances. The overvoltage spike can be calculated as follows:

$$V_{CE} \text{ (Peak)} = V_{CE} + L \bullet dI/dt.$$

Here $V_{CE}$ signifies the collector-emitter voltage, dI/dt is the current change with time, and L is the value of the parasitic inductivity.

In order to avoid parasitic inductances in the power circuit, the lay-out of the circuit becomes important. As this is generally known, the parasitic inductance rises with the area encircled by the electric current. With an overlap of the tracks of positive and negative voltage the area becomes minimal. Capacitors are used to shorten these loops in order to reduce the encircled area.

The power module is a key component regarding the parasitic inductance. Here the target in bridge configurations has to be to shortcut of the encircled area of the DC input and to reduce same as far as possible by means of a capacitor. The distance between the DC+ and the DC- contacts and the accessibility of these contacts will influence the system inductance and the switch-off losses.

EP 1 143 603 A shows a power conversion device for generating a three-phase alternating current which, for instance, can be applied to an induction motor. On the other hand, the semiconductor device can also convert a three-phase alternating voltage into an internal DC voltage. In order to keep the inductivity as low as possible and in order to thereby reduce voltage peaks, the two DC current terminals are formed as plates which are insulated from each other and form a side wall of the housing. Between the two DC terminals, a capacitor is connected. A further capacitor can be provided between the positive DC terminal and the negative DC terminal. Thus, an alternative current path is provided for the switch-on current.

EP 0 379 346 A relates to a power module with power switches, which each have a snubber circuit for suppressing peak voltages. Although these snubber circuits might be interpreted generally as an alternative current path for switching currents, the snubber circuits according to this document are only used to bypass the semiconductor switch, but are not arranged to provide an alternative feed line path

From US 5,907,475 A a circuit board system for a motor controller circuit is known, wherein the power circuit is arranged on a separate circuit carrier, and wherein the capacitors are assembled on a circuit board of their own which is inserted perpendicularly into the mother board. The interconnection of the components to each other is for instance shown in figure 1 of this document. According to this figure, the capacitors are connected between the two DC input lines 38 and 40.

US 2005/225955 A1 relates to a multilayer circuit board having a supply voltage plane and a reference voltage plane. A signal plane is arranged in a way that noise which is present on the power supply plane is shielded from the signal plane by the ground plane that is arranged there between, and vice versa.

EP 1 768 244 A discloses a snubber circuit in a power semiconductor device which is connected ahead of a gate turnoff (GTO) thyristor. The series snubber circuit consists of an anode reactor including an inductor formed by a coil, and a series connection formed of a SiC pn diode and a resistance which is connected in parallel to the anode reactor.

The principles according to the present invention can be applied in particular to power modules using insulated gate bipolar transistors, IGBT, for frequency control of three phase electromotors. Here the power module is structured as an IGBT half bridge with the possibility to combine three modules to form a three-phase inverter bridge.

The problem underlying the present invention is to provide a power module which has a reduced cost and assembly complexity on the one hand and a reduced parasitic inductance enabling fast switching applications on the other hand.

This object is solved by the subject matter of the independent claim 1. Advantageous embodiments of the present invention are the subject matter of the dependent claims.

The present invention is based on the idea that by providing a low inductive transient current path for carrying the transient current during the switching operation of the semiconductor switch, over voltage spikes which are caused during the switching operation of the semiconductor switch are reduced and do not damage the semiconductor. The transient currents are deviated in a transient current path. Thus, the current flow in the power module can be separated into a path with extremely low inductivity for the transient current during the switching of the high voltage, and a main path for the continuous current which has a low ohmic resistance, but does not have to be designed to have a specifically low inductance. With a low inductive current path for the transient current overvoltage spikes are avoided or at least reduced. The overvoltage at switch-off at the semiconductor will be reduced.

The transient current path having the low inductivity is active only during the short time wherein dl/dt is high during switching. On the other hand, the connections for this low-inductivity path will not face the thermal load of the high current because of the short duration of same.

According to an advantageous embodiment of the present invention, the transient current path is at least partly arranged in a plane which is oriented across to the circuit substrate carrying the semiconductor switch. Thus, the low-inductivity current path can for instance be integrated into a connection element which is present for the continuous current inside the power module.

For instance, the transient current path can at least partly be formed as a sandwich of at least two electrically conductive sheets, preferably fabricated from stamped and bent metal sheets. This is a particularly easy and cost efficient way of fabricating a contact bridge with integrated transient current path.

For electrically insulating the conductive sheets from each other, an electrically insulating foil can be provided. These foils, for instance fabricated from polyimide, have the advantage that they can be assembled easily and do not require much space.

Alternatively, the transient current path can also be partly formed as a separate multilayer printed circuit board. In this case, a plurality of conductive layers can be provided in a particularly space-saving way.

According to an advantageous embodiment of the present invention, the transient current path comprises at least one capacitor for storing the charge of the transient current during the switching operation of the semiconductor switch. In this case, the energy is absorbed in the capacitor which can be mounted in a way that it can be effectively cooled, as this is known in the art.

For a better understanding of the present invention same will be explained in the following based on the embodiments shown in the figures. Corresponding parts are given corresponding reference numerals and terms. Furthermore, those features or combinations of features which show or described different embodiments may form separate inventive solutions in themselves. The invention will now be described by way of example with reference to the drawings, wherein:

**Fig. 1** is a circuit diagram of a power module according to a first advantageous em- bodiment;

**Fig. 2** is a circuit diagram of a power module according to a second advantageous embodiment;

**Fig. 3** is a schematic perspective view of a power module with a transient current path according to a first embodiment;

**Fig. 4** is a circuit diagram of a power module system comprising two half bridges ac- cording to a first embodiment;

**Fig. 5** is a circuit diagram of a power module system comprising two half bridges ac- cording to a second embodiment;

**Fig. 6** is a schematic perspective view of a transient current path according to a sec- ond advantageous embodiment;

**Fig. 7** is a perspective view of a power module system comprising three power mod- ules and forming a three-phase inverter bridge.

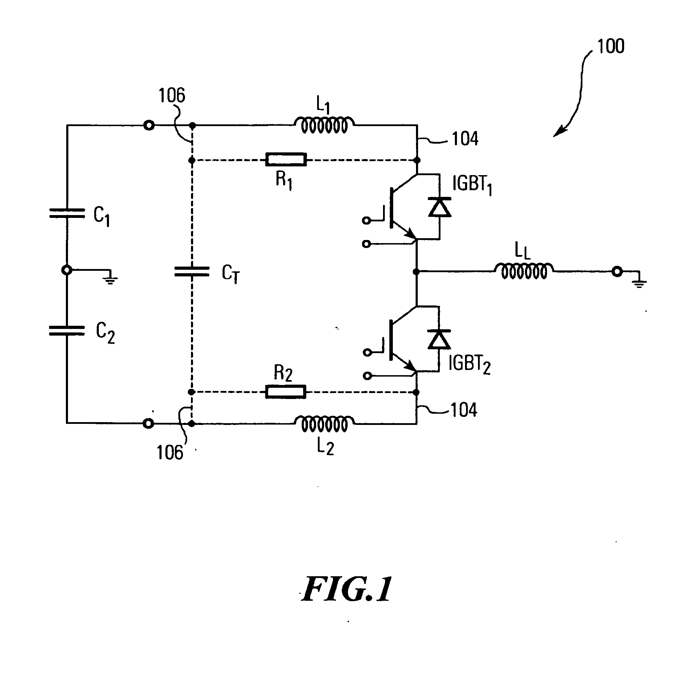

Fig. 1 shows a schematic circuit diagram of a power module 100 according to the present invention in a first embodiment. The power module 100 is structured as a half bridge comprising two insulated gate bipolar transistors, IGBT, connecting a DC input to a load $L_L$. According to the present invention, the current flow in the power module 100 is separated into a transient path 102 with extremely low inductivity for the transient current during switching the high voltage and a main path 104 having a low resistance for the continuous current. The discrete elements L1, R1 and L2, R2 represent the distributed parasitic inductivities and resistances of the respective current paths. As shown in figure 1, the main current path 104 does not have a significant ohmic resistance, but only a measurable inductivity L1 and L2.

On the other hand, the inventive transient current path 102 exhibits a measurable ohmic resistance R1, R2, but is designed in a way that it is extremely low in inductivity. Although due to the ohmic resistance the transient current path would not be able to carry the thermal load of the continuous current, it is well capable of carrying the short term current of the switching transient current.

The transient current path 102 having the low inductivity is only active during the short time when dI/dt is high at switch on and off of IGBT1 and IGBT2, respectively. The connections for this low inductive transient current path therefore will not face the thermal load of the high current because of the short duration of current flow.

As indicated by the connections 106, the transient current paths 102 and the main current paths 104 can optionally be connected to each other. In case that the connections 106 are not present, a capacitor CT has to be provided for absorbing the energy of the transient current.

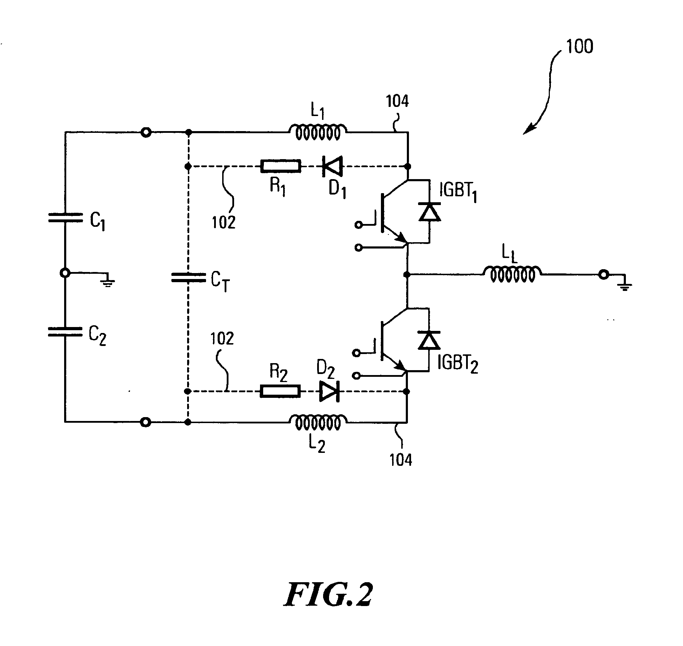

Fig. 2 shows a further embodiment of the power module 100 wherein two diodes D1 and D2 are provided in the transient current path 102 for assigning only the switch-off current to the transient current path with low inductivity 102.

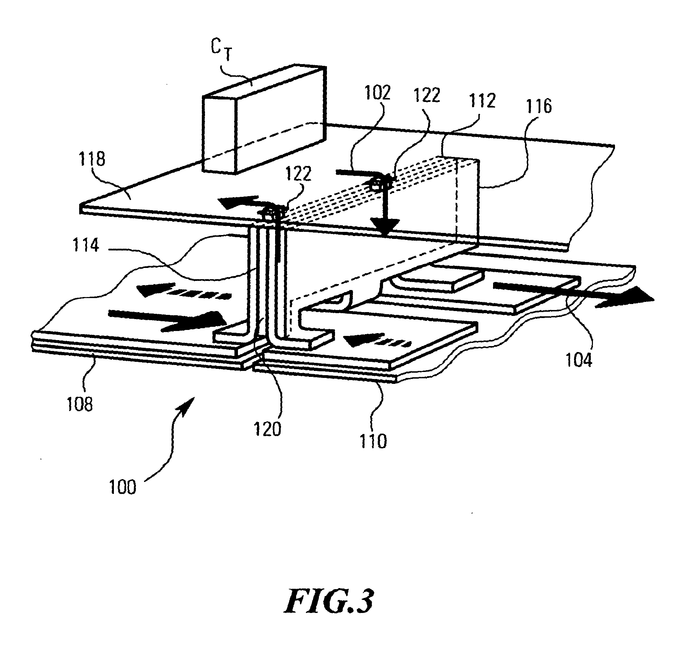

Fig. 3 shows in a schematic perspective view a first possibility of mechanically realizing the inventive transient current path 102.

As this is known to a person skilled in the art, power modules 100 are often designed with several DCB (direct copper bonding) substrates 108, 110. These first and second substrates 108, 110 have to be connected to each other electrically by means of a conductive bridge. Normally, these bridges 112 represent an additional source of parasitic inductance. According to the present invention, however, the bridge 112 is formed in a way that it has minimized parasitic inductivity. According to the embodiment of figure 3, it is formed by two stamped and bent metal sheets. The two metal sheets 114, 116 are bent in a way that a first part of the sheet is connected to the first circuit substrate 108 and a second part is bent to be connected to the second substrate 110.

The two sheets 114, 116 establish in this way two main current paths 104, which are leading in two directions. According to the present invention, via printed circuit board (PCB) 118 a further transient current path 102 is formed. The two metal sheets 114, 116 are arranged in parallel and are insulated from each other by means of a dielectric material 120, so that the inductivity of the transient current path 102 is minimal. As shown schematically in Fig. 3, the dielectric material 120 for instance can be a foil preferably made from polyimide, which is wrapped around the metal sheet 116.

According to the present invention as shown in figure 3, the printed circuit board carries a transient current capacitor CT for absorbing the energy of the transient voltage spike in the transient current path 102. This way of assembly allows an easy and efficient cooling of the capacitor CT. The connection to the printed circuit board 118 is formed by means of protrusions, in the following called "contact fingers", 122 formed at the first and second metal sheets 114, 116.

According to this embodiment, the transient current 102 on the substrates 108, 110 is routed in a low inductive way over the printed circuit board 118 to the capacitor CT. The continuous current 104 is assigned to the external connection. The parasitic inductivity of the internal connection will not influence the transient current.

The advantage of the present invention can be seen in the possibility to design modules for fast-switching, high-power applications without the effort of complex construction of the external connections. In high-power modules the external connection often is a screw connector with massive copper bars. A low-inductive connection here is expensive and with the inventive idea and the improvement of the anyway necessary bridges 112 between the substrate, a very cost-effective solution to the problem can be provided. Consequently, due to the lower switch-off losses the efficiency is increased and a higher DC voltage can be switched due to the reduced voltage overshot at switch off.

The inventive solution can be used for power modules with screw connections, particularly with power modules having more than one substrate, which can be used in motor drives, uninterruptible power supplies (UPS), or solar inverters.

For some applications, for instance zero voltage switching (ZVS), the same low inductive path right parallel to the switches is needed. For three level inverters for instance, three signals with low inductivity regarding to each other are necessary. Therefore, also a third conductive sheet (not shown in the figures) with a second insulation layer there between, can be provided. Again, in order to achieve a reliable electrically insulation between the conductive sheets the insulation foil can be wrapped around the metal sheets.

The inventive concept which was explained above for a power module comprising two insulated gate bipolar transistors can also be extended to more complex power module systems which use a combination of two or more power modules 100.

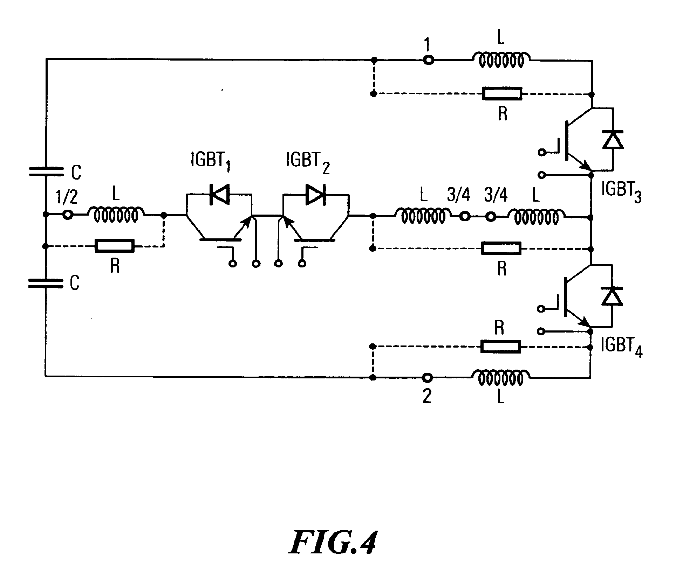

Fig. 4 shows a first arrangement of two power modules, one comprising IGBT1 and IGBT2, and the other comprising IGBT3 and IGBT4. Again, transient current paths 102, which possess a low inductivity and a measurable ohmic resistance are provided for carrying the transient current during switch-off. The inductivities represent the parasitic inductivities of the main current paths 104. In Fig. 4, the inductivities L designate the parasitic inductances, whereas R signifies the parasitic resistances.

With the power module system of Fig. 4 a higher power can be switched by distributing same onto two modules comprising IGBT1 and IGBT2, and IGBT3 and IGBT4, respectively.

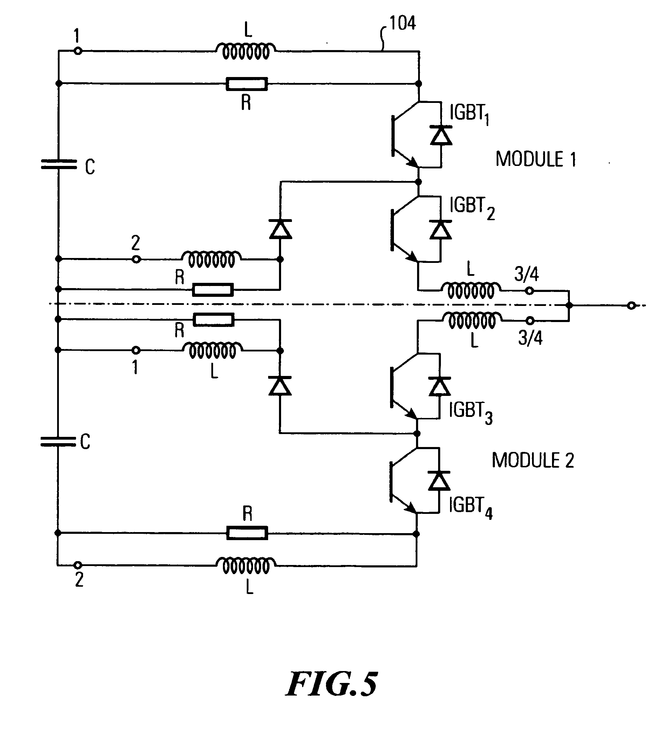

Still another system constituted by two power modules according to the present invention is shown in Fig. 5. Here, the two power modules are connected in parallel to each other. Again, the inductivities and resistances designate the parasitic inductivities and the reference numerals 1, 2, 3 and 4 designate the screw connections of a four screw module.

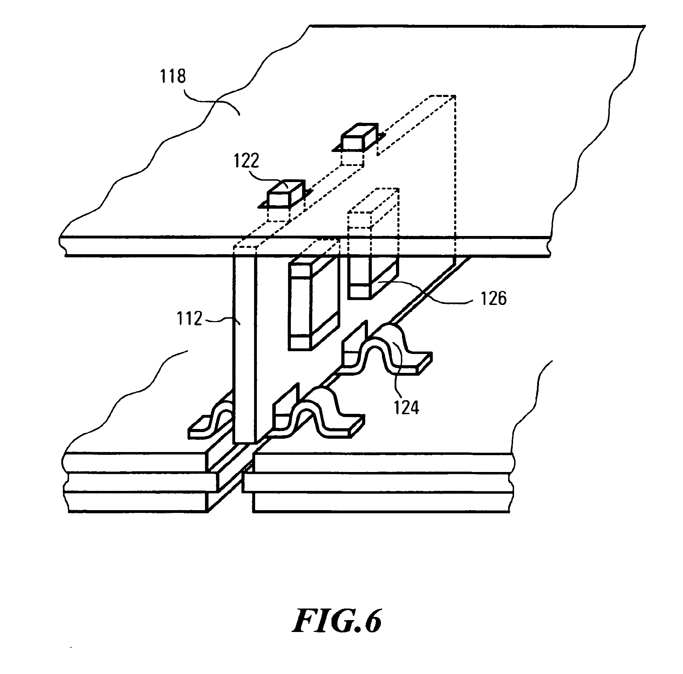

Fig. 6 shows in a perspective view an alternative embodiment of a connecting bridge 112. According to this embodiment, the bridge element 112 is formed by a printed circuit board. The advantage of this arrangement can be seen in the fact that when for instance using a four-layer printed circuit board, relevant potentials can be carried layered above each other. For contacting the substrates 108, 110, smaller metal bridges 124 are provided. Contact fingers 122 are formed on the bridge element 112 for contacting the printed circuit board 118. These fingers 122 lead the respective potential on the outside and the corresponding voltage on the inner layers. In the remaining area of the bridge element 112 positive and negative voltages are layered above each other in an alternating way. For instance, the layers of a bridge element having four metal layers can be arranged as follows.

**Table 1:**

Layers of the printed circuit board (outside, inside, inside, outside)

| | |
|---|---|
| Finger 1: | + - - + |
| Finger 2: | - + + - |
| Rest of PCB: | + - + - |

(contact pads to the metal bridge 124 in correspondence to the fingers.)

Consequently, the voltage potentials overlap almost completely. In the region of the contact fingers 122 the current carrying regions do not completely overlap in order to comply with the necessary security distances. Because always the respectively other voltage potential is opposite, a capacitor effect is generated and thus a transformer which is short-circuited at the output, wherein the inductivity is mostly compensated by means of added currents.

The bridge element 112 can be formed by any known circuit carrier technique, such as printed circuit board, ceramic circuit carrier etc. The metal bridge 124 is preferably formed as a lead frame. Furthermore, the embodiment using a circuit carrier as the bridge element 112 has the advantage that additional capacitors 126 can be mounted thereon.

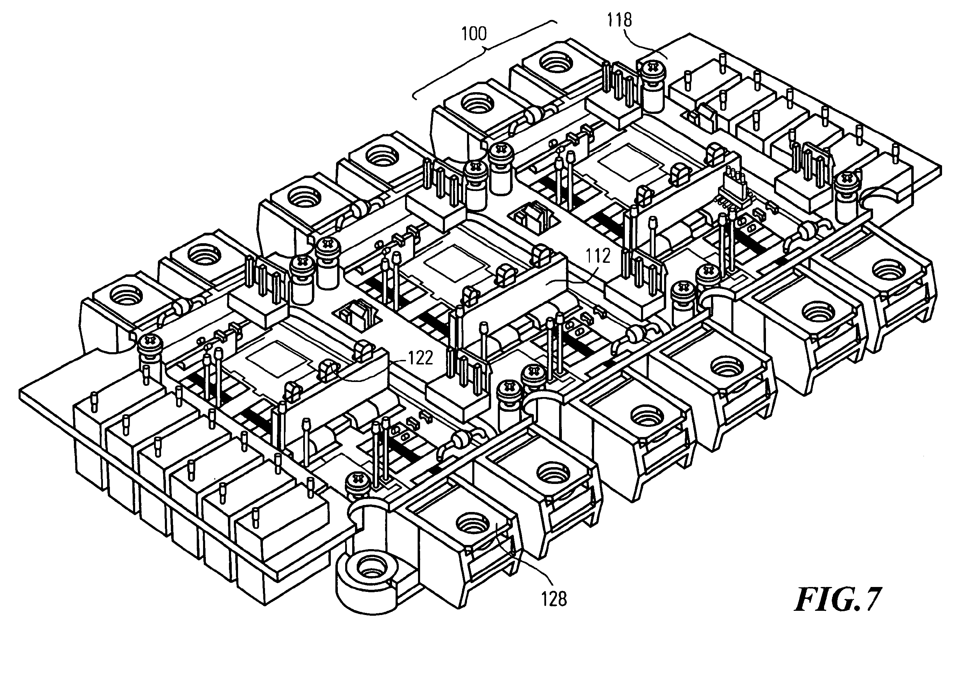

Fig. 7 shows a perspective view of a three-level inverter using three power modules according to the present invention. In the embodiment of figure 7 three modules are combined with one common printed circuit board 118. The coupling of several modules generates the following advantages: Firstly, the residue inductivity from the screw connecting point to the external capacitor is to be divided by the number of terminals. In this case the already low inductivity is further reduced to one third. Secondly, the capacitors which are assembled on the printed circuit board 118 can be used by all three modules and consequently the performance is improved and the expenditure is reduced.

Optionally, the printed circuit board can also be connected to the screw connections 128 so that all screw connections are commonly screwed and generate a low inductive path to the capacitors. In this case, the capacitors are of additional advantage but not compulsory for the functioning of the circuit. Coupled module systems like the one shown in figure 7 can either be formed by coupling three half bridges with one common circuit board and one bridge element 112 each, wherein each module has the structure of Fig. 1 or Fig. 2. Alternatively, also three NPC power modules, as shown in Fig. 4 and 5, can be coupled as one power module system.

One power module contains each the complete circuit of figure 4 or 5. The combination of these three modules is coupled via a common circuit board 118. Such neutral point clamped (NPC) or three leveled topologies have the additional characteristic that in addition to the screw terminals of the three basic modules the terminal of the neutral point has to be led to the outside by means of one or more screwed clamps on the printed circuit board. Because these clamps are also connected with external capacitors, these terminals are led out on the same side as the positive and negative DC terminals. In Fig. 4 and 5 the neutral point is connected on the left-hand side, DC plus on the above side, DC minus on the lower side and AC output on the right-hand side with respect to the figure.

Power module systems according to the present invention comprising at least two power modules can be used advantageously in a great variety of designs and configurations. According to a first advantageous embodiment, the transient current path of each power module (100) is connected with a common printed circuit board, PCB, or the transient current paths are connected in parallel.

Furthermore, the system can be a three-phase inverter, wherein a three-phase three-level topology is used. As shown in Fig. 5, the low inductive path can be provided also between the output (3/4) and the neutral point (centre point between the capacitors). This design will improve also reactive switching.

According to a still further advantageous embodiment, the common PCB is connected with the main path e. g. via an overlap of the PCB with the screw contacts (128).

**Claims**

1.    Power module for controlling an input current to provide an output current, said power module (100) comprising:

at least one semiconductor switch (IGBT$_{1...4}$) for controlling the input current,
a circuit substrate (108, 110) having at least one input terminal for being connected to an input voltage and at least one output terminal for outputting the output voltage, wherein the input terminal and the output terminal are connected to each other via a main current path (104) that is controlled by the semiconductor switch, wherein said power module further comprises at least one transient current path (102) for carrying a transient current during a switching operation of the semiconductor switch, wherein said transient current path has a lower distributed parasitic inductivity than the main current path, and wherein said main current path has a lower distributed parasitic ohmic resistance than the transient current path, and wherein said transient current path (102) is arranged in parallel with said main current path (104) between said input terminal and a first terminal of said semiconductor switch.

2. Power module according to claim 1, wherein said transient current path is at least partly arranged in a plane which is oriented across to said circuit substrate.

3. Power module according to one of the preceding claims, wherein said transient current path is at least partly formed as a sandwich of at least two electrically conductive sheets (114, 116).

4. Power module according to claim 3, wherein said electrically conductive sheets (114, 116) are insulated from each other by means of an electrically insulating foil.

5. Power module according to one of the preceding claims, wherein said transient current path (102) is at least partly formed as a separate multilayer printed circuit board.

6. Power module according to claim 5, wherein said multilayer printed circuit is connected to the circuit substrate in a way that positive and negative potentials are layered with alternating polarity.

7. Power module according to one of the preceding claims, wherein said transient current path comprises at least one capacitor (CT) for storing a charge of the transient current during the switching operation of the semiconductor switch.

8. Power module according to claim 7, wherein said capacitor is arranged on a separate circuit carrier (118) which is mounted essentially in parallel to said circuit substrate.

9. Power module according to one of the preceding claims, wherein said transient current path (102) comprises at least one diode for assigning only a switch-off current to the transient current path.

10. Power module system comprising at least two power modules (100) according to one of the preceding claims.

11. System according to claim 10 wherein three power modules forming a three-phase three-level topology are assembled on one common printed circuit board (118).

**Patentansprüche**

1. Leistungsmodul zum Regeln eines Eingangsstroms, um einen Ausgangsstrom bereitzustellen, wobei das Leistungsmodul (100) umfasst:

mindestens einen Halbleiterschalter (IGBT$_{1...4}$) zum Regeln des Eingangsstroms,
einen Schaltungsträger (108, 110) mit mindestens einem Eingangsanschluss zum Verbinden mit einer Eingangsspannung und mit mindestens einem Ausgangsanschluss zum Ausgeben der Ausgangsspannung, wobei der Eingangsanschluss und der Ausgangsanschluss miteinander über einen Hauptstrompfad (104) verbunden sind, der durch den Halbleiterschalter gesteuert wird, wobei das Leistungsmodul weiterhin mindestens einen transienten Strompfad (102) zum Führen eines transienten Stromes während einer Schaltoperation des Halbleiterschalters umfasst, wobei der transiente Strompfad eine geringere verteilte parasitäre Induktivität als der Hauptstrompfad aufweist, und wobei der Hauptstrompfad einen geringeren verteilten parasitären ohmschen Widerstand als der transiente Strompfad aufweist, und wobei der transiente Strompfad (102) parallel zu dem Hauptstrompfad (104) zwischen dem Eingangsanschluss und einem ersten Anschluss des Halbleiterschalters angeordnet ist.

**2.** Leistungsmodul nach Anspruch 1, wobei der transiente Strompfad wenigstens teilweise in einer Ebene angeordnet ist, die quer zu dem Schaltungsträger orientiert ist.

**3.** Leistungsmodul nach einem der vorhergehenden Ansprüche, wobei der transiente Strompfad zumindest teilweise als Schichtstruktur aus mindestens zwei elektrisch leitfähigen Schichten (114, 116) gebildet ist.

**4.** Leistungsmodul nach Anspruch 3, wobei die elektrisch leitfähigen Schichten (114, 116) voneinander mit Hilfe einer elektrisch isolierenden Folie isoliert sind.

**5.** Leistungsmodul nach einem der vorhergehenden Ansprüche, wobei der transiente Strompfad (102) zumindest teilweise durch eine separate Mehrschichtleiterplatte gebildet ist.

**6.** Leistungsmodul nach Anspruch 5, wobei die Mehrschichtleiterplatte mit dem Schaltungsträger in einer Weise verbunden ist, dass die positiven und negativen Potentiale mit alternierender Polarität geschichtet sind.

**7.** Leistungsmodul nach einem der vorhergehenden Ansprüche, wobei der transiente Strompfad mindestens einen Kondensator (CT) zum Speichern einer Ladung des transienten Stromes während der Schaltoperation des Halbleiterschalters aufweist.

**8.** Leistungsmodul nach Anspruch 7, wobei der Kondensator auf einem separaten Schaltungsträger (118) angeordnet ist, der im Wesentlichen parallel zu dem Schaltungsträger montiert ist.

**9.** Leistungsmodul nach einem der vorangehenden Ansprüche, wobei der transiente Strompfad (102) mindestens eine Diode aufweist, um dem transienten Strompfad nur einen Ausschaltstrom zuzuweisen.

**10.** Leistungsmodulsystem umfassend mindestens zwei Leistungsmodule (100) nach einem der vorhergehenden Ansprüche.

**11.** System nach Anspruch 10, wobei drei Leistungsmodule, die eine Dreiphasen-Dreipunkt-Topologie bilden, auf einem gemeinsamen gedruckten Schaltungsträger (118) angeordnet sind.

**Revendications**

**1.** Module d'alimentation pour commander un courant d'entrée afin de fournir un courant de sortie, le module d'alimentation (100) comprenant :

au moins un interrupteur à semi-conducteur ($IGBT_{1...4}$) qui commande le courant d'entrée,
un substrat de circuit (108, 110) qui a au moins une borne d'entrée à relier à une tension d'entrée et au moins une borne de sortie pour fournir la tension de sortie, étant précisé que la borne d'entrée et la borne de sortie sont reliées entre elles par l'intermédiaire d'un trajet de courant principal (104) qui est commandé par l'interrupteur à semi-conducteur,
étant précisé que le module d'alimentation comprend par ailleurs au moins un trajet de courant transitoire (102) pour porter un courant transitoire pendant une opération de commutation de l'interrupteur à semi-conducteur, que ledit trajet de courant transitoire a une inductance parasite répartie plus faible que le trajet de courant principal, et que le trajet de courant principal a une résistance ohmique parasite répartie plus faible que le trajet de courant transitoire, et
étant précisé que le trajet de courant transitoire (102) est disposé parallèlement au trajet de courant principal (104) entre la borne d'entrée et une première borne de l'interrupteur à semi-conducteur.

**2.** Module d'alimentation selon la revendication 1, dans lequel le trajet de courant transitoire est au moins en partie disposé dans un plan qui est orienté transversalement par rapport au substrat de circuit.

**3.** Module d'alimentation selon l'une des revendications précédentes, dans lequel le trajet de courant transitoire est au moins en partie formé comme un sandwich d'au moins deux feuilles conductrices d'électricité (114, 116).

**4.** Module d'alimentation selon la revendication 3, dans lequel les feuilles conductrices d'électricité (114, 116) sont isolées l'une de l'autre par une feuille électriquement isolante.

**5.** Module d'alimentation selon l'une des revendications précédentes, dans lequel le trajet de courant transitoire (102) est au moins en partie formé comme une carte de circuit imprimé multicouche séparée.

**6.** Module d'alimentation selon la revendication 5, dans lequel le circuit imprimé multicouche est relié au substrat de circuit de telle sorte que les potentiels positif et négatif soient prévus en couches avec une polarité alternée.

**7.** Module d'alimentation selon l'une des revendications précédentes, dans lequel le trajet de courant transitoire comprend au moins un condensateur (CT) pour stocker une charge de courant transitoire pendant l'opération de commutation de l'interrupteur à semi-conducteur.

**8.** Module d'alimentation selon la revendication 7, dans lequel le condensateur est disposé sur un support de circuit séparé (118) qui est monté essentiellement parallèlement au substrat de circuit.

**9.** Module d'alimentation selon l'une des revendications précédentes, dans lequel le trajet de courant transitoire (102) comprend au moins une diode pour attribuer seulement un courant de blocage au trajet de courant transitoire.

**10.** Système de modules d'alimentation comprenant au moins deux modules d'alimentation (100) selon l'une des revendications précédentes.

**11.** Système selon la revendication 10, dans lequel trois modules d'alimentation formant une topologie triphasée à trois niveaux sont assemblés sur une carte de circuit imprimé (118) commune.

**FIG.1**

**FIG.2**

**FIG.3**

**FIG.4**

**FIG.5**

**FIG.6**

*FIG.7*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1143603 A
- EP 0379346 A
- US 5907475 A
- US 2005225955 A1
- EP 1768244 A